# EUROPEAN PATENT APPLICATION

(11) **EP 2 642 273 A2**
(43) Date of publication of application: **25.09.2013**
(21) Application number: 13001435.0
(22) Date of filing: 20.03.2013
(51) Int. Cl.: G01N 1/32

(54) **Glow discharge milling apparatus and glow discharge milling method**

(30) Priority: 21.03.2012 JP 2012064219
(71) Applicant: Horiba, Ltd, Kyoto 601-8510 (JP)
(72) Inventor: Fujimoto, Akira, Kyoto-shi, Kyoto, 601-8510 (JP); Nakamura, Tatsuhito, Kyoto-shi, Kyoto, 601-8510 (JP)
(74) Representative: Müller - Hoffmann & Partner

(57) **Abstract**

A glow discharge milling apparatus milling a sample by using glow discharge includes: a glow discharge tube 2 applying a voltage between an electrode and a sample so as to generate glow discharge; an operation part 67 receiving a mixing ratio by which inert gas and oxygen gas are to be mixed with each other; MFCs 54, in accordance with the mixing ratio received by the operation part 67, controlling the amounts of supply of the inert gas and the oxygen gas; and a mixer 55 mixing the inert gas and the oxygen gas with each other in accordance with the amounts of supply controlled by the MFCs 54 and then supplying the mixed gas to the glow discharge tube 2 through the pipe S P.

## Description

### FIELD OF THE INVENTION

The present invention relates to a glow discharge milling apparatus and a glow discharge milling method for milling a sample surface by using sputtering associated with glow discharge.

### BACKGROUND OF THE INVENTION

A technique is known that a sample surface serving as a target of observation or analysis is milled by using glow discharge (for example, see Japanese Patent Publication No. 4143620. At that time, the gas used for sputtering is an inert gas or alternatively a mixed gas obtained by combining inert gases. On the other hand, a technique is known that for the purpose of forming a thermal head used in a thermal printer, sputtering is performed by using a mixed gas consisting of argon and oxygen (for example, see Japanese Patent Application Laid-Open No. H10-305603).

Meanwhile, the present inventor has found that when gas obtained by mixing oxygen gas into inert gas is used in sputtering, a high smoothness is obtained in the sample surface after processing. Nevertheless, an increase in the mixing ratio of oxygen gas causes a decrease in the etching rate. On the other hand, when the mixing ratio of oxygen gas is reduced, although the etching rate is increased, the smoothness in the sample surface after processing is reduced. Thus, a suitable mixing ratio of oxygen gas used in sputtering depends on the kind of sample.

### SUMMARY OF THE INVENTION

The present invention has been devised in view of this situation. An object thereof is to provide a glow discharge milling apparatus and a glow discharge milling method in which the partial pressure of oxygen in the mixed gas consisting of inert gas and oxygen gas is set up appropriately in accordance with the sample.

The glow discharge milling apparatus according to the present invention is characterized by a glow discharge milling apparatus milling a sample by using glow discharge generated by, in an atmosphere of mixed gas supplied through a pipe to a glow discharge tube, applying a voltage between an electrode located inside the glow discharge tube and the sample placed opposite to the electrode, including: a reception part receiving a mixing ratio by which inert gas and oxygen gas are to be mixed with each other; a control part, in accordance with the mixing ratio received by the reception part, controlling the amounts of supply of the inert gas and the oxygen gas; and a supply unit mixing the inert gas and the oxygen gas with each other in accordance with the amounts of supply controlled by the control part and then supplying the mixed gas to the glow discharge tube through the pipe.

The glow discharge milling apparatus according to the present invention, receives a mixing ratio by which inert gas and oxygen gas are to be mixed with each other, and then controls the amounts of supply of the inert gas and the oxygen gas in accordance with the received mixing ratio. The glow discharge milling apparatus mixes the inert gas and the oxygen gas with each other in accordance with the controlled amounts of supply and then supplies the mixed gas to the glow discharge tube through the pipe. Then, in an atmosphere of the supplied mixed gas, the glow discharge milling apparatus generates glow discharge by applying a voltage between the electrode located inside the glow discharge tube and the sample and thereby mills the sample.

The glow discharge milling apparatus according to the present invention is characterized by a glow discharge milling apparatus milling a sample by using glow discharge generated by, in an atmosphere of mixed gas supplied through a pipe to a glow discharge tube, applying a voltage between an electrode located inside the glow discharge tube and the sample placed opposite to the electrode, including: a detection part detecting an auto-bias voltage value associated with a voltage generated on a surface of the sample on which the voltage is applied; a storage part storing auto-bias voltage values and mixing ratios of the inert gas and the oxygen gas in correspondence to each other; a retrieval part, on the basis of the auto-bias voltage value detected by the detection part, retrieving a mixing ratio from the contents stored in the storage part; a control part, in accordance with the mixing ratio retrieved by the retrieval part, controlling the amounts of supply of the inert gas and the oxygen gas; and a supply unit mixing the inert gas and the oxygen gas with each other in accordance with the amounts of supply controlled by the control part and then supplying the mixed gas to the glow discharge tube through the pipe.

The glow discharge milling apparatus according to the present invention detects an auto-bias voltage value associated with a voltage generated on the surface of the sample on which a voltage is applied. Then, on the basis of the detected auto-bias voltage value, the glow discharge milling apparatus retrieves a mixing ratio from the storage part storing auto-bias voltage values and mixing ratios of inert gas and oxygen gas in correspondence to each other. The glow discharge milling apparatus controls the amounts of supply of the inert gas and the oxygen gas in accordance with the retrieved mixing ratio. The glow discharge milling apparatus mixes the inert gas and the oxygen gas with each other in accordance with the controlled amounts of supply and then supplies the mixed gas to the glow discharge tube through the pipe. Then, in an atmosphere of the supplied mixed gas, the glow discharge milling apparatus generates glow discharge by applying a voltage between the electrode located inside the glow discharge tube and the sample and thereby mills the sample.

The glow discharge milling apparatus according to the present invention is characterized by a glow discharge milling apparatus milling a sample by using glow discharge generated by, in an atmosphere of mixed gas supplied through a pipe to a glow discharge tube, applying a voltage between an electrode located inside the glow discharge tube and the sample placed opposite to the electrode, including: a reception part receiving the kind of the sample; a storage part storing the kinds of samples and mixing ratios of the inert gas and the oxygen gas in correspondence to each other; a retrieval part, on the basis of the kind of sample received by the reception part, retrieving a mixing ratio from the contents stored in the storage part; a control part, in accordance with the mixing ratio retrieved by the retrieval part, controlling the amounts of supply of the inert gas and the oxygen gas; and a supply unit mixing the inert gas and the oxygen gas with each other in accordance with the amounts of supply controlled by the control part and then supplying the mixed gas to the glow discharge tube through the pipe.

The glow discharge milling apparatus according to the present invention receives the kind of sample and then, on the basis of the received kind of sample, retrieves a mixing ratio from the storage part storing the kinds of samples and mixing ratios of inert gas and oxygen gas in correspondence to each other. The glow discharge milling apparatus controls the amounts of supply of the inert gas and the oxygen gas in accordance with the retrieved mixing ratio. The glow discharge milling apparatus mixes the inert gas and the oxygen gas with each other in accordance with the controlled amounts of supply and then supplies the mixed gas to the glow discharge tube through the pipe. Then, in an atmosphere of the supplied mixed gas, the glow discharge milling apparatus generates glow discharge by applying a voltage between the electrode located inside the glow discharge tube and the sample and thereby mills the sample.

The glow discharge milling apparatus according to the present invention is **characterized in that**: the storage part stores the materials of samples, mixing ratios, and milling rates in correspondence to each other; when the sample is a stacked material obtained by stacking different materials in a milling direction, the reception part receives the kind of material, the order of stacking, and the thickness of each layer; on the basis of the kind of material of each layer received by the reception part, the retrieval part retrieves a mixing ratio and a milling rate from the contents stored in the storage part; and in the order of stacking received by the reception part and on the basis of the thickness of each layer received by the reception part and the milling rate retrieved by the retrieval part, the control part determines timing in which the amounts of supply of the inert gas and the oxygen gas are to be changed and then, in accordance with the mixing ratio retrieved by the retrieval part, controls the amounts of supply of the inert gas and the oxygen gas , respectively, at the determined timing.

In the glow discharge milling apparatus according to the present invention, the storage part stores the kinds of material of samples, mixing ratios of inert gas and oxygen gas, and milling rates in correspondence to each other. When the sample is a stacked material obtained by stacking different materials in a milling direction, the glow discharge milling apparatus receives the kind of material, the order of stacking, and the thickness of each layer in the sample. Then, on the basis of the received kind of material of each layer, the glow discharge milling apparatus retrieves a mixing ratio of inert gas and oxygen gas and a milling rate from the contents stored in the storage part. In the received order of stacking of the layers and on the basis of the received thickness of each layer and the retrieved milling rate, the glow discharge milling apparatus determines timing in which the amounts of supply of the inert gas and the oxygen gas are to be changed and then, in accordance with the retrieved mixing ratio, controls the amounts of supply of the inert gas and the oxygen gas at the determined timing. The glow discharge milling apparatus mixes the inert gas and the oxygen gas with each other in accordance with the controlled amounts of supply and then supplies the mixed gas to the glow discharge tube through the pipe. Then, in an atmosphere of the supplied mixed gas, the glow discharge milling apparatus generates glow discharge by applying a voltage between the electrode located inside the glow discharge tube and the sample and thereby mills the sample.

The glow discharge milling apparatus according to the present invention is characterized by including: a measuring instrument measuring the intensity of light emission generated by glow discharge; and an identification part, on the basis of the intensity of light emission measured by the measuring instrument, identifying the kind or material of the sample, wherein on the basis of the kind or material of the sample identified by the identification part, the retrieval part retrieves a mixing ratio from the contents stored in the storage part.

The glow discharge milling apparatus according to the present invention measures the intensity of light emission generated by glow discharge and then, on the basis of the measured intensity of light emission, identifies the kind or the kind of material of the sample. Then, on the basis of the identified kind or the identified kind of material of the sample, the glow discharge milling apparatus retrieves a mixing ratio from the contents stored in the storage part. The glow discharge milling apparatus controls the amounts of supply of the inert gas and the oxygen gas in accordance with the retrieved mixing ratio. The glow discharge milling apparatus mixes the inert gas and the oxygen gas with each other in accordance with the controlled amounts of supply and then supplies the mixed gas to the glow discharge tube through the pipe. Then, in an atmosphere of the supplied mixed gas, the glow discharge milling apparatus generates glow discharge by applying a voltage between the electrode located inside the glow discharge tube and the sample and thereby mills the sample.

The glow discharge milling method according to the present invention is characterized by a glow discharge milling method of milling a sample by using glow discharge generated by, in an atmosphere of mixed gas supplied through a pipe to a glow discharge tube, applying a voltage between an electrode located inside the glow discharge tube and the sample placed opposite to the electrode, including: controlling the amounts of supply of the inert gas and the oxygen gas at an arbitrary ratio of the amounts of supply; mixing the inert gas and the oxygen gas for the controlled amounts of supply; and supplying the mixed gas to the glow discharge tube through the pipe.

In the glow discharge milling method according to the present invention, the amounts of supply of inert gas and oxygen gas are controlled at an arbitrary ratio of the amounts of supply. Then, in the glow discharge milling method, the inert gas and the oxygen gas are mixed with each other in accordance with the controlled amounts of supply , respectively, and then the mixed gas is supplied to the glow discharge tube through the pipe. Then, in the glow discharge milling method, in an atmosphere of the supplied mixed gas, glow discharge is generated by applying a voltage between the electrode located inside the glow discharge tube and the sample , so as to mill the sample.

According to an aspect of disclosure in the present application, the partial pressure of oxygen in the mixed gas consisting of inert gas and oxygen gas is set up appropriately in accordance with the property of a sample.

The object and advantages of the invention will be realized and attained by the elements and combinations particularly pointed out in the claims. It is to be understood that both the foregoing general description and the following detailed description are exemplary and explanatory and are not restrictive of the embodiment, as claimed.

### BRIEF DESCRIPTION OF DRAWINGS

FIG. 1 is a block diagram illustrating outlines of an exemplary hardware configuration of a glow discharge milling apparatus.
FIG. 2 is a flow chart illustrating an example of a procedure of glow discharge milling processing.
FIGS. 3A and 3B represent examples of scanning electron microscope photographs each obtained , respectively, before and after milling processing using argon gas alone.
FIGS. 4A and 4B represent examples of scanning electron microscope photographs each obtained , respectively, before and after milling processing using mixed gas consisting of argon gas and oxygen gas.
FIGS. 5A and 5B represent examples of scanning electron microscope photographs each obtained , respectively, before and after milling processing using mixed gas consisting of argon gas and oxygen gas.
FIG. 6 is an explanation diagram illustrating an example of record layout of an auto-bias voltage mixing-ratio table.
FIG. 7 is a flow chart illustrating an example of a procedure of glow discharge milling processing.
FIG. 8 is a flow chart illustrating an example of a procedure of glow discharge milling processing.
FIG. 9 is an explanation diagram illustrating an example of record layout of a kind-of-sample mixing-ratio table.
FIG. 10 is a flow chart illustrating an example of a procedure of glow discharge milling processing.
FIG. 11 is a flow chart illustrating an example of a procedure of glow discharge milling processing.
FIG. 12 is a block diagram illustrating outlines of an exemplary hardware configuration of a glow discharge milling apparatus according to Embodiment 4.
FIG. 13 is a flow chart illustrating an example of a procedure of glow discharge milling processing.
FIG. 14 is a flow chart illustrating an example of a procedure of glow discharge milling processing.

### DETAILED DESCRIPTION OF THE EMBODIMENTS

A glow discharge milling apparatus according to the present embodiment is used for generating a sample surface to be observed by an observation instrument or alternatively a sample surface to be analyzed by an analyzing instrument. Observation instruments employable here include an optical microscope, a scanning electron microscope, a transmission electron microscope, a scanning transmission electron microscope, and an X-ray microscope. Analyzing instruments employable here include an X-ray photoelectron spectrometer, an Auger electron spectrograph, a SIMS (Secondary Ion-microprobe Mass Spectrometer), and an EPMA (Electron Probe Micro Analyzer).

The gas used in the glow discharge milling apparatus according to the present embodiment is a mixed gas consisting of inert gas and oxygen gas. Inert gases used here include helium gas, neon gas, argon gas, krypton gas, xenon gas, and mixed gas containing these gases. In the following description, the glow discharge milling apparatus performs sputtering of a sample surface by using mixed gas consisting of argon and oxygen.

Samples to be milled by the glow discharge milling apparatus according to the present embodiment include inorganic substances, organic substances, and mixtures of inorganic substances and organic substances. Such samples include metallic materials, organic materials, ceramics, glass materials, plastics, stones, minerals, cosmetics, bones, organic single crystal semiconductors, and hybrid multilayer samples consisting of metals/glass materials/organic substances.

### Embodiment 1

Embodiment 1 relates to a mode that the partial pressure of oxygen in mixed gas of argon and oxygen is manually changed in accordance with the property of the sample.

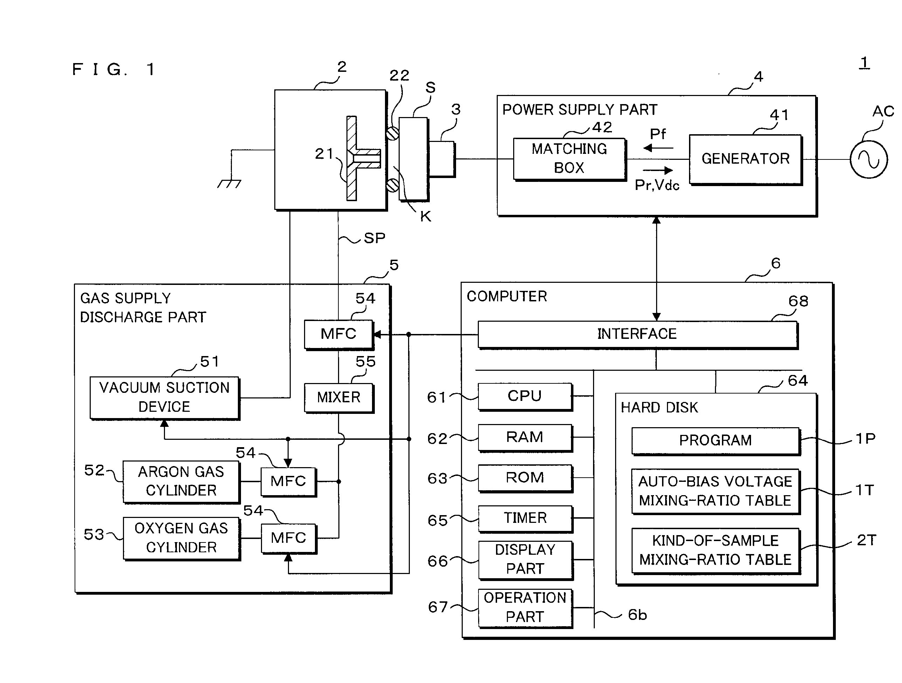

FIG. 1 is a block diagram illustrating outlines of an exemplary hardware configuration of a glow discharge milling apparatus 1. The glow discharge milling apparatus 1 includes a glow discharge tube 2, a sample pressing member 3, a power supply part 4, a gas supply discharge part 5, and a computer 6.

The glow discharge tube 2 generates glow discharge on a sample S to be milled. The glow discharge tube 2 includes an anode (electrode) 21 and an O-ring 22.
The anode 21 is located at a position biased from a substantial center of the glow discharge tube 2 toward the sample S. The anode 21 includes a disk part and a cylindrical part. The surface of the disk part is substantially in parallel to the surface of the sample S to be milled. Then, the cylindrical part protrudes in a direction extending from the center of the disk part to the sample S. The sample-S-side end of the cylindrical part reaches the vicinity of an opening provided in one end surface of the glow discharge tube 2 opposite to the sample S. Here, the anode 21 is grounded.

The O-ring 22 is provided in the surroundings of the above-mentioned opening. The sample S is arranged such that the to-be-milled surface is oriented toward the glow discharge tube 2 and abuts against the O-ring 22. When the sample S is placed, a space K surrounded by the O-ring 22 forms a closed space. In the space K, the supplied mixed gas is changed into plasma.

The sample pressing member 3 presses the sample S toward the glow discharge tube 2. Further, the sample pressing member 3 serves also as an electrode through which a voltage is applied to the sample S. In the glow discharge milling apparatus 1, the sample S on which the voltage is applied serves as a cathode.

The power supply part 4 is connected to an AC power supply AC. The power supply part 4 generates a high-frequency power. Then, by virtue of the generated high-frequency power, a high-frequency voltage is applied between the anode 21 and the sample S through the sample pressing member 3. Two modes are available in the high-frequency voltage applied between the anode 21 and the sample S from the power supply part 4. The two modes are a continuous mode and an intermittent mode. In the continuous mode, the power supply part 4 generates a continuous high-frequency power during a certain period of time and thereby applies a continuous high-frequency voltage between the anode 21 and the sample S. On the other hand, in the intermittent mode, the power supply part 4 generates an intermittent high-frequency power during a certain period of time and thereby applies an intermittent high-frequency voltage between the anode 21 and the sample S. The power supply part 4 is connected to the computer 6 and thereby switches the voltage-application mode in response to an instruction from the computer 6.

The power supply part 4 includes a generator (a detection part) 41 and a matching box 42. When the voltage-application mode is of intermittent mode, the generator 41 generates a high-frequency power corresponding to the supply frequency and the duty ratio instructed from the computer 6. The generator 41 detects an output value Pf indicating the power value of the forward wave travelling toward the sample pressing member 3 and a reflection value Pr indicating the power value of the reflected wave generated by reflection of the forward wave in the sample S. Further, the generator 41 detects a voltage (referred to as an auto-bias voltage Vdc) generated on the surface of the sample S onto which the high-frequency voltage is applied. The impedance value of the sample S varies as milling progresses. Then, the generator 41 adjusts the output value Pf such that the difference (Pf-Pr) between the output value Pf and the reflection value Pr is maintained constant.

The matching box 42 contains a variable capacitor whose electric capacity is changed by driving by a motor. When the voltage-application mode is of continuous mode, the matching box 42 adjusts the module and the phase by using the variable capacitor and thereby minimizes the reflection value Pr of the reflected wave returned from the sample S. In this manner, when the voltage-application mode is of continuous mode, the matching box 42 maintains constant the output value Pf associated with the high-frequency power generated by the generator 41.

The gas supply discharge part 5 includes a vacuum suction device 51, an argon gas cylinder 52, an oxygen gas cylinder 53, MFCs (control parts) 54, and a mixer (a supply unit) 55. Here, the argon gas cylinder 52 and the oxygen gas cylinder 53 may be excluded in the constituting parts of the glow discharge milling apparatus 1.

The vacuum suction device 51 is a vacuum pump for generating vacuum in the space K of the glow discharge tube 2. For example, the vacuum suction device 51 is constructed from a rotary pump, a diffusion pump, and a turbo-molecular pump. The vacuum suction device 51 and the glow discharge tube 2 are connected to each other through a pipe. In the glow discharge tube 2, an exhaust hole is provided that penetrates through between the pipe and the space K. The vacuum in the space K is generated by the vacuum suction device 51 through the pipe and the exhaust hole. The vacuum suction device 51 is connected to the computer 6 and operated in response to an instruction from the computer 6.
Here, a user may manually control the vacuum suction device 51 directly.

The argon gas cylinder 52 and the oxygen gas cylinder 53 contain argon gas which is an inert gas and oxygen gas, respectively.

Two MFCs (mass flow controllers) 54 are respectively connected to the argon gas cylinder 52 and the oxygen gas cylinder 53 through pipes. The two MFCs 54 controls the mass flow rates of the argon gas and the oxygen gas in accordance with the mixing ratio specified from the computer 6. Further, one MFC 54 is arranged in a middle of a supply pipe (a pipe) SP connecting the mixer 55 to the glow discharge tube 2. The two MFCs 54 and the one MFC 54 are connected to the computer 6.
The MFCs 54 control the mass flow rates of fluids. However, in place of the MFCs 54, volume flow control devices controlling the volume flow rates of fluids may be employed. In this case, the volume flow control devices control the volume flow rates of the argon gas and the oxygen gas.

The mixer 55 is connected to the two MFCs 54 and the one MFC 54 respectively through the pipe and the supply pipe SP. The mixer 55 mixes uniformly the argon gas and the oxygen gas whose flow rates are respectively controlled by the two MFCs 54. The mixer 55 supplies the uniformly mixed gas to the one MFC 54 through the supply pipe SP. Then, the one MFC 54 supplies to the glow discharge tube 2 the mixed gas having undergone flow control. The glow discharge tube 2 is provided with a gas supply hole penetrating through between the space K and the supply pipe SP connected to the mixer 55. That is, the mixer 55 supplies the mixed gas to the space K through the one MFC 54, the supply pipe SP, and the gas supply hole.

The computer 6 includes a CPU (a retrieval part and an identification part) 61, a RAM (Random Access Memory) 62, a ROM (Read Only Memory) 63, a hard disk (a storage part) 64, a timer 65, a display part 66, an operation part (a reception part) 67, and an interface 68. The individual constituting parts of the computer 6 are connected to each other through a bus 6b.

The CPU 61 is a processor controlling the power supply part 4 and the gas supply discharge part 5. The CPU 61 reads into the RAM 62 a program 1P stored in the hard disk 64, and then executes the program 1P.

The RAM 62 temporarily stores working variables, data, and the like necessary in the course of processing performed by the CPU 61. Here, the RAM 62 is an example of a main storage device. Thus, in place of the RAM 62, a flash memory, a memory card, or the like may be employed.

The ROM 63 is a read-only storage medium , for example, a nonvolatile semiconductor memory or a memory other than semiconductor The ROM 63 stores a BIOS (Basic Input/Output System), firmware, and the like executed by the CPU 61 at the time of startup of the computer 6.

The hard disk 64 stores the program 1P executed by the CPU 61. The hard disk 64 may be built in the computer 6 and may be located outside the computer 6. Here, the hard disk 64 is an example of an auxiliary storage unit and may be substituted by a flash memory capable of recording a large size of information or by an optical disks such as a CD (Compact Disc), a DVD (Digital Versatile Disk), or a BD (Blu-ray Disc, registered trademark). In this case, the computer 6 includes a disk drive reading information from the optical disk and recording information onto the optical disk.

The hard disk 64 stores an auto-bias voltage mixing-ratio table 1T and a kind-of-sample mixing-ratio table 2T. The auto-bias voltage mixing-ratio table 1T stores the auto-bias voltage Vdc and the mixing ratio of argon gas and oxygen gas in the mixed gas, in correspondence to each other. The kind-of-sample mixing-ratio table 2T stores the kind of sample and the mixing ratio of argon gas and oxygen gas in the mixed gas, in correspondence to each other.

The timer 65 performs time counting of date and time, and then transmits a signal of the time counting result to the CPU 61.
The display part 66 has a screen such as a liquid crystal display and an organic electroluminescence (Electro-Luminescence) display, and displays various kinds of screens concerning the program 1P in response to an instruction from the CPU 61.

The operation part 67 includes input devices such as a keyboard and a mouse used by the user for performing various kinds of inputs. On the basis of the operation performed by the user, the operation part 67 generates an input signal. The generated input signal is transmitted through the bus 6b to the CPU 61.

The interface 68 includes devices, circuits, and connectors for connecting the power supply part 4 and the gas supply discharge part 5 to the computer 6 so as to establish transmission and reception of information.

Next, operation of the glow discharge milling apparatus 1 is described below.

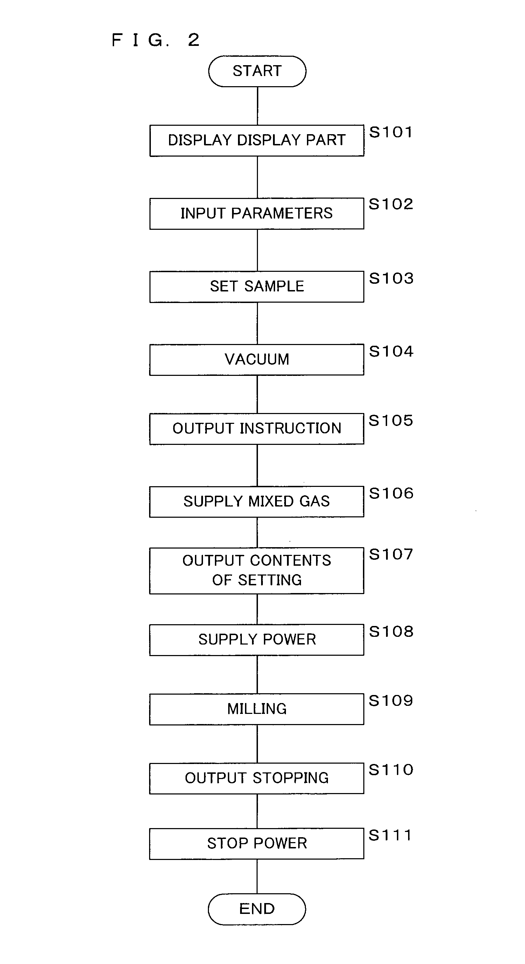

FIG. 2 is a flow chart illustrating an example of a procedure of glow discharge milling processing. The procedure of FIG. 2 is used when a mixing ratio of argon gas and oxygen gas suitable for the sample S is known.
The CPU 61 displays on the display part 66 an input screen (not illustrated) used for inputting various kinds of parameters such as a voltage-application mode, a frequency, a duty ratio, a milling time, and a mixing ratio for the mixed gas (step S101). The user inputs various kinds of parameters to the input screen through the operation part 67 (step S102). The user sets the sample S in the glow discharge tube 2 (step S103).

The CPU 61 causes the vacuum suction device 51 to perform vacuum suction of the glow discharge tube 2 (step S104). The CPU 61 outputs an instruction to each MFC 54 such that the flow rates of the argon gas and the oxygen gas are controlled in accordance with the received mixing ratio (step S105). The mixer 55 mixes uniformly the argon gas and the oxygen gas whose flow rates are respectively controlled by the MFCs 54, and then supplies the uniformly mixed gas into the glow discharge tube 2 (step S106). The CPU 61 outputs to the power supply part 4 the received contents of setting (step S107).

The power supply part 4 starts voltage application in accordance with the contents of setting based on the instruction from the CPU 61 (step S108). Thus, milling of the surface of the sample S is performed under the mixed gas atmosphere with which the space K is filled(step S109). On the basis of time counting obtained from the timer 65, when the received milling time has elapsed, the CPU 61 outputs to the power supply part 4 an instruction of stopping voltage application (step S110). When receiving from the CPU 61 the instruction of stopping voltage application, the power supply part 4 stops voltage application (step S111) and then terminates the processing.

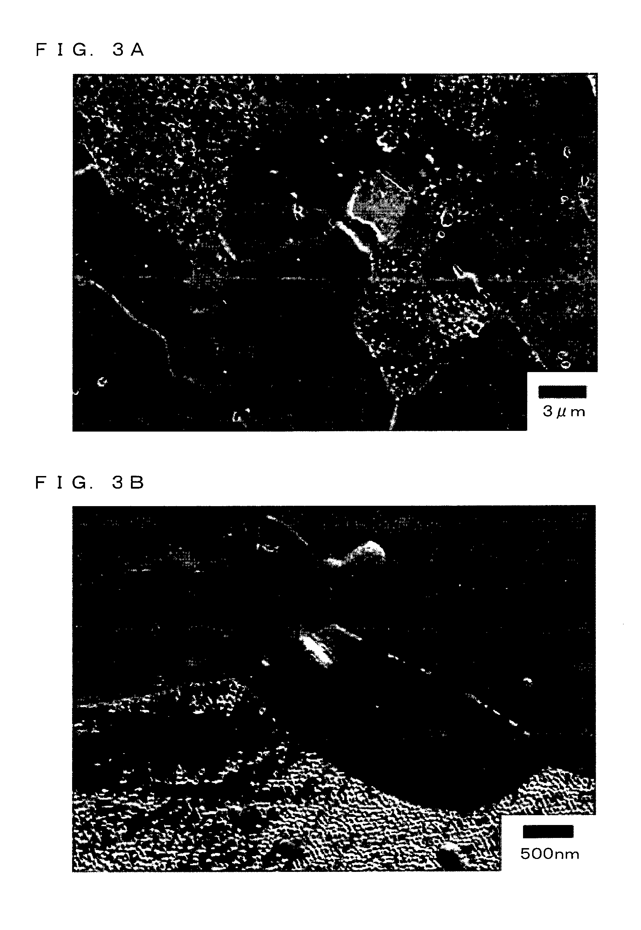

FIGS. 3A and 3B represent examples of scanning electron microscope photographs obtained , respectively, before and after milling processing using argon gas alone. The sample S employed in FIGS. 3A and 3B is stainless steel. FIG. 3A is an example of a scanning electron microscope photograph obtained before milling processing. The scale bar located at the lower right corner in FIG. 3A indicates 3 µm. FIG. 3B is an example of a scanning electron microscope photograph obtained after milling processing. The scale bar located at the lower right corner in FIG. 3B indicates 500 nm.

In FIG. 3A, it is recognized that the sample S is of polycrystalline substance. On the other hand, in FIG. 3B, for example, a fine texture in two mutually crossing directions is clearly recognized in the crystal grain in the lower part. Further, a deposited substance is recognized in the grain boundary near the center of FIG. 3B. Nevertheless, although the sample S surface is observed in FIG. 3B, the situation of the deposited substance on the deeper side than the sample S surface is unobserved. When sputtering of the sample is performed further by using argon gas alone, the sample S surface becomes rough and hence observation of texture, deposited substance, and inclusion in the sample S becomes unachievable.

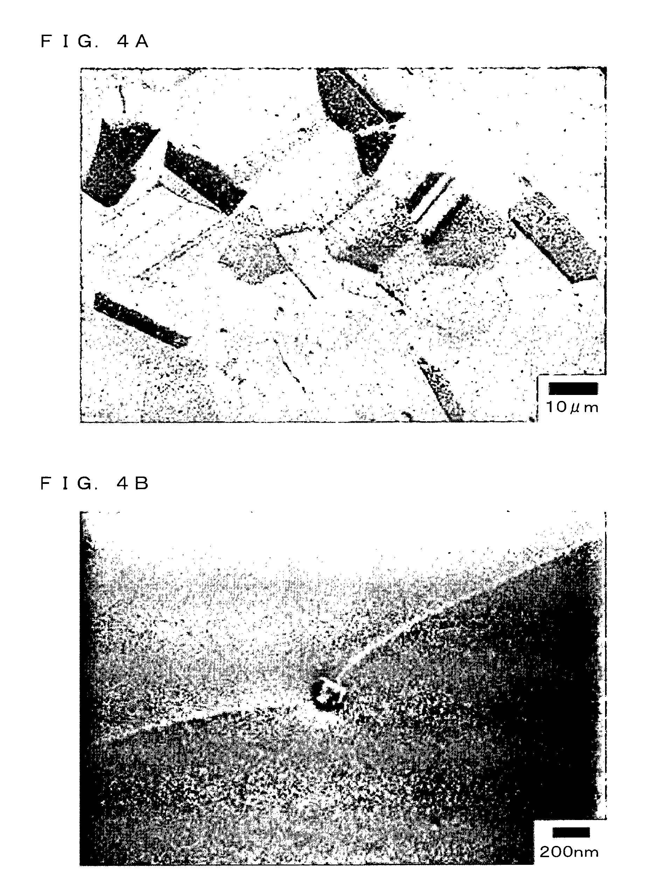

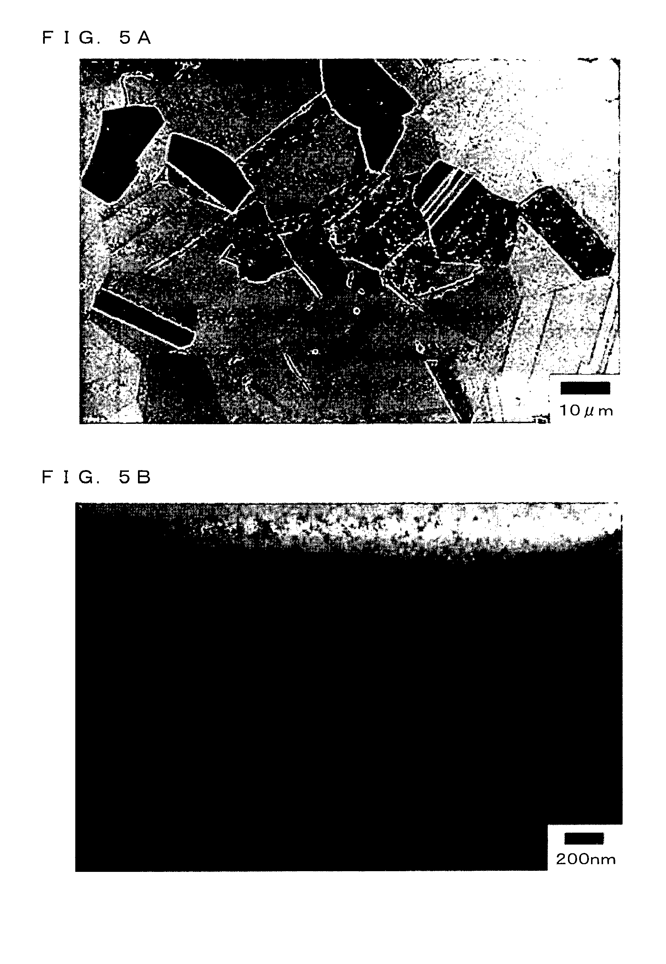

FIGS. 4A, 4B, 5A, and 5B represent examples of scanning electron microscope photographs each obtained before and after milling processing using mixed gas consisting of argon gas and oxygen gas. The sample S employed in FIGS. 4A, 4B, 5A, and 5B is of stainless steel. Further, in the cases of FIGS. 4A, 4B, 5A, and 5B, the ratio of argon gas to the entire mixed gas is 5 % by weight.
FIG. 4A is an example of a scanning electron microscope photograph obtained with an Out lens before milling processing. The scale bar located at the lower right corner in FIG. 4A represents 10 µm. FIG. 4B is an example of a scanning electron microscope photograph obtained with an Out lens after milling processing. The scale bar located at the lower right corner in FIG. 4B indicates 200 nm.
FIG. 5A is an example of a scanning electron microscope photograph obtained with an In lens before milling processing. The scale bar located at the lower right corner in FIG. 5A indicates 10 µm. FIG. 5B is an example of a scanning electron microscope photograph obtained with an In lens after milling processing. The scale bar located at the lower right corner in FIG. 5B indicates 200 nm.

The acceleration voltage employed in the photographing of FIGS. 4A, 4B, 5A, and 5B is 1.00 kV. The working distance is 3 mm, and the grid voltage is 999 V. The MAG mode in the photographing of FIGS. 4A and 5A is ×1.01K. The MAG mode in the photographing of FIGS. 4B and 5B is ×37.91K.

Also in FIGS. 4A and 5A, it is recognized that the sample S is polycrystalline. In FIGS. 4B and 5B, the fine texture observed in FIG. 3B is not observed. However, the smoothness of the sample S surface in FIGS. 4B and 5B is much higher than the smoothness of the sample S surface in FIG. 3B. Deposited substance is recognized in the grain boundary near the center of FIGS. 4B and 5B. When milling of the sample S is performed with mixed gas obtained by mixing oxygen gas into argon gas, the milling rate is slow. Thus, starting at the state of FIGS. 4B and 5B, when milling further progresses, the sample S surface at several stages in the depth direction is allowed to be observed until the deposited substance near the center of FIGS. 4B and 5B is sputtered completely.

In the present embodiment, adjustment of the mixing ratio of argon gas and oxygen gas through the MFCs 54 has been performed by the computer 6. However, adjustment of the mixing ratio of argon gas and oxygen gas through the MFCs 54 may be performed directly by the user operating the MFCs 54.

Further, in the present embodiment, the mixed gas has been generated from the gases in the argon gas cylinder 52 and the oxygen gas cylinder 53 and then the generated mixed gas has been supplied to the glow discharge tube 2. Instead, a mixed gas having a desired mixing ratio may be contained in a gas cylinder in advance and then the mixed gas may be directly supplied from the gas cylinder to the glow discharge tube 2.
In this case, a plurality of gas cylinders respectively containing a plurality of types of mixed gas having different mixing ratios may be prepared in advance. Then, the plurality of gas cylinders may be connected to the glow discharge tube 2 through pipes. A bulb is provided in each pipe connecting each of the plurality of gas cylinders to the glow discharge tube 2. Thus, when a corresponding bulb is opened, the desired mixed gas alone is supplied to the glow discharge tube 2.

According to the glow discharge milling apparatus 1, the partial pressure of oxygen in the mixed gas consisting of inert gas and oxygen gas is set up appropriately in accordance with the property of a sample.
In the mixed gas, an optimum mixing ratio optimizing the milling rate and the smoothness of the sample S surface is present for each sample S. For example, the mixing ratio may be expressed by the partial pressure of oxygen in the mixed gas. When oxygen gas is introduced in the sputtering gas, oxygen radicals are generated in the plasma. The oxygen radicals form an oxide film in the sample S surface by virtue of a strong oxidization force. This oxide film has an effect of suppressing the sputtering of the sample S achieved by argon ions. Thus, the introduction of oxygen gas in the sputtering gas reduces the milling rate and hence has an effect of making the sample S surface more smooth after processing.

For example, when EBSD analysis (crystal orientation analysis) is to be performed with a scanning electron microscope, it is important for the sample S surface of a target of measurement to have a roughness-free surface. According to the glow discharge milling apparatus 1, a roughness-free surface is always generated in the direction of milling of the sample S. This permits 3-D analysis in EBSD analysis.
Further, when the element distribution or the chemical composition of the sample S surface is to be analyzed, the sample S surface needs be smooth. According to the glow discharge milling apparatus 1, a smooth sample S surface suitable for the analyzing instrument is generated in a short time.

### Embodiment 2

Embodiment 2 relates to a mode that the mixing ratio in the mixed gas of argon and oxygen is automatically changed on the basis of the auto-bias voltage Vdc. In Embodiment 2, the auto-bias voltage mixing-ratio table 1T is used.

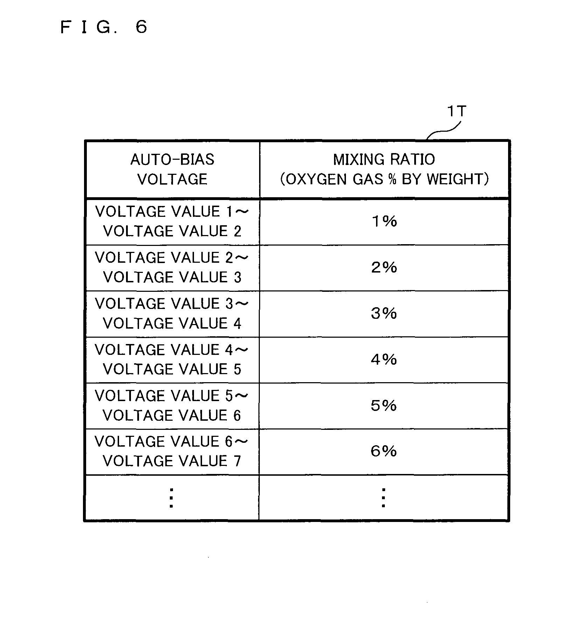

FIG. 6 is an explanation diagram illustrating an example of record layout of the auto-bias voltage mixing-ratio table 1T. The auto-bias voltage mixing-ratio table 1T contains columns of auto-bias voltage and mixing ratio. The auto-bias voltage Vdc is a voltage generated on the surface of the sample S onto which the high-frequency voltage is applied, and is detected by the generator 41. The auto-bias voltage Vdc varies depending on the impedance values of the sample S, and hence is different for each kind of sample. In the column of auto-bias voltage in the auto-bias voltage mixing-ratio table 1T, a voltage value range such as a voltage value 1 to a voltage value 2 is stored in each row.
The mixing ratio indicates the mixing ratio of argon gas and oxygen gas. For example, the mixing ratio is expressed by the weight-percentage of oxygen gas relative to the entire mixed gas. The auto-bias voltage Vdc and a suitable mixing ratio are determined in advance for each of samples S having various impedance values, and then the auto-bias voltage mixing-ratio table 1T is prepared.

Next, operation of the glow discharge milling apparatus 1 based on the auto-bias voltage Vdc is described below.

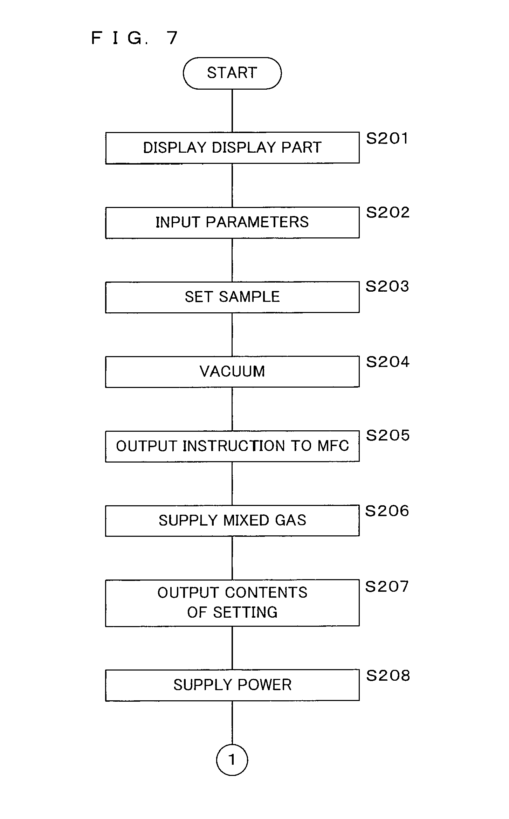

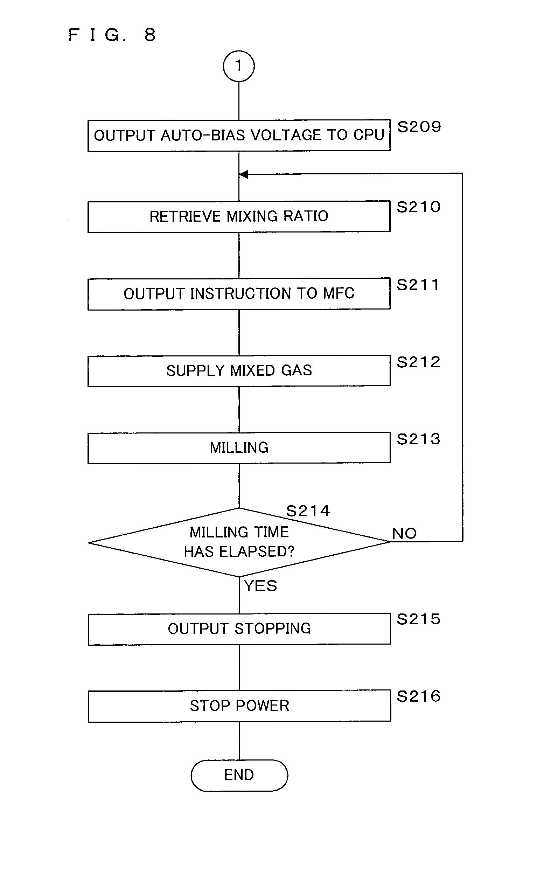

FIGS. 7 and 8 are flow charts illustrating an example of a procedure of glow discharge milling processing. The procedure of FIGS. 7 and 8 is used when the kind of sample for the sample S and the mixing ratio for the mixed gas are unknown.
The CPU 61 displays on the display part 66 an input screen (not illustrated) used for inputting various kinds of parameters such as a voltage-application mode, a frequency, a duty ratio, and a milling time (step S201). The user inputs various kinds of parameters in the input screen through the operation part 67 (step S202). The user sets the sample S in the glow discharge tube 2 (step S203).

The CPU 61 causes the vacuum suction device 51 to perform vacuum suction of the glow discharge tube 2 (step S204). The CPU 61 outputs an instruction to each MFC 54 such that the flow rates of the argon gas and the oxygen gas are controlled in accordance with a mixing ratio of initial setting (step S205). Here, the mixing ratio of initial setting is stored in advance in the hard disk 64. Then, the CPU 61 acquires from the hard disk 64 the mixing ratio of initial setting. The mixer 55 uniformly mixes the mixed gas having the mixing ratio of initial setting consisting of argon gas and oxygen gas whose flow rates are controlled by the MFCs 54, and then supplies the uniformly mixed gas into the glow discharge tube 2 (step S206). The CPU 61 outputs to the power supply part 4 the received contents of setting (step S207). The power supply part 4 starts voltage application in accordance with the contents of setting based on the instruction from the CPU 61 (step S208).

The generator 41 detects the auto-bias voltage Vdc and then outputs the detected auto-bias voltage Vdc to the CPU 61 (step S209). Here, during the detection of the auto-bias voltage Vdc, the generator 41 continues outputting the continuously detected auto-bias voltage Vdc to the CPU 61. On the basis of the auto-bias voltage Vdc acquired from the generator 41, the CPU 61 retrieves a mixing ratio from the auto-bias voltage mixing-ratio table 1T (step S210). The CPU 61 outputs an instruction to each MFC 54 such that the flow rates of the argon gas and the oxygen gas are controlled in accordance with the retrieved mixing ratio (step S211).

The mixer 55 mixes uniformly the argon gas and the oxygen gas whose flow rates are controlled by the MFCs 54, and then supplies the uniformly mixed gas into the glow discharge tube 2 (step S212). Thus, milling of the surface of the sample S is performed under the mixed gas atmosphere with which the space K is filled (step S213). On the basis of the time counting obtained from the timer 65, the CPU 61 determines whether the received milling time has elapsed (step S214).

When it is determined that the received milling time has not yet elapsed (step S214: NO), the CPU 61 returns the procedure to step S210. When it is determined that the received milling time has elapsed (step S214: YES), the CPU 61 outputs to the power supply part 4 an instruction of stopping voltage application (step S215). When receiving from the CPU 61 the instruction of stopping voltage application, the power supply part 4 stops voltage application (step S216) and then terminates the processing.

In Embodiment 2, the mixing ratio has been obtained by using the auto-bias voltage mixing-ratio table 1T. Instead, the mixing ratio may be obtained by substituting the auto-bias voltage Vdc value into an approximation formula prepared in advance. When this approach is to be adopted, first, an auto-bias voltage Vdc and a suitable mixing ratio are determined for each of samples S having various impedance values. Then, an approximation formula representing the correlation between the auto-bias voltage Vdc and the mixing ratio is generated and stored into the hard disk 64.
Then, at step S210 in FIG. 8, on the basis of the auto-bias voltage Vdc acquired from the generator 41, the CPU 61 calculates the mixing ratio from the above-mentioned approximation formula.

According to the glow discharge milling apparatus 1, at the time of milling the sample S, even when the kind of sample of the sample S and the mixing ratio for the mixed gas are unknown, the mixing ratio is set up automatically.
The glow discharge milling apparatus 1 automatically controls the mixing ratio on the basis of the detected auto-bias voltage Vdc. Thus, in addition to the case of a sample consisting of a single kind, even in the case of a sample S obtained by stacking several different kinds of materials and the case of a sample S in which deposited substance is buried, the mixing ratio is changed successively on the basis of the detected auto-bias voltage Vdc. Thus, milling is performed always with a suitable mixing ratio. That is, in the course of the processing of milling the sample S, when the kind or material to be milled varies, the mixing ratio is automatically changed in accordance with the kind or material having varied.

The present Embodiment 2 is as described above. The other points are similar to those in Embodiment 1. Thus, like parts are designated by like reference numerals, and their detailed descriptions are omitted.

### Embodiment 3

Embodiment 3 relates to a mode that when the kind of sample is known, the mixing ratio in the mixed gas of argon and oxygen is automatically set by specifying of the kind of sample. In Embodiment 3, the kind-of-sample mixing-ratio table 2T is used.

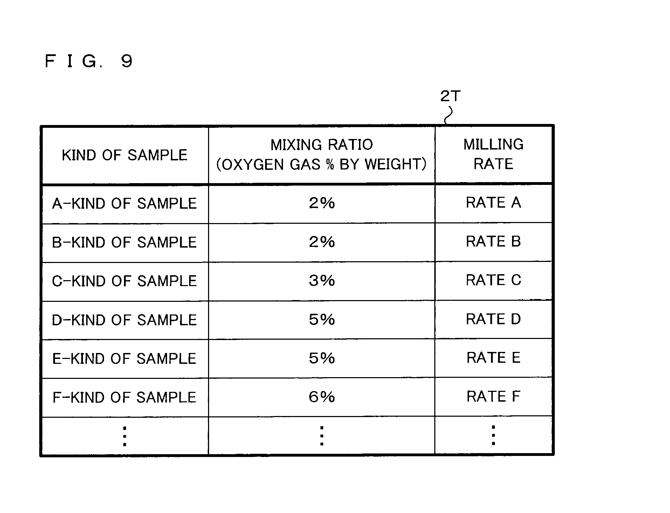

FIG. 9 is an explanation diagram illustrating an example of record layout of the kind-of-sample mixing-ratio table 2T. The kind-of-sample mixing-ratio table 2T contains columns of the kind of sample, mixing ratio, and milling rate. The kind of sample is the kind of the sample S. For example, in a case that samples S are composed of a metallic material, the samples S are recognized as mutually different with respect to the kind of sample when their metal textures of the metallic material are different from each other. Further, when the metallic materials of samples S are in mutually different phases in terms of crystallographical or thermodynamical properties, the samples S are recognized as mutually different with respect to the kind of sample.

The mixing ratio indicates the mixing ratio of argon gas and oxygen gas. For example, the mixing ratio is expressed by the weight-percentage of oxygen gas relative to the entire mixed gas.
The milling rate indicates the amount of progress of milling per unit time. For example, the employed unit is nm/s.
A suitable mixing ratio and a milling rate in the mixing ratio are measured in advance for each known sample S, and then the kind-of-sample mixing-ratio table 2T is prepared.

Next, operation of the glow discharge milling apparatus 1 based on the kind of sample is described below.

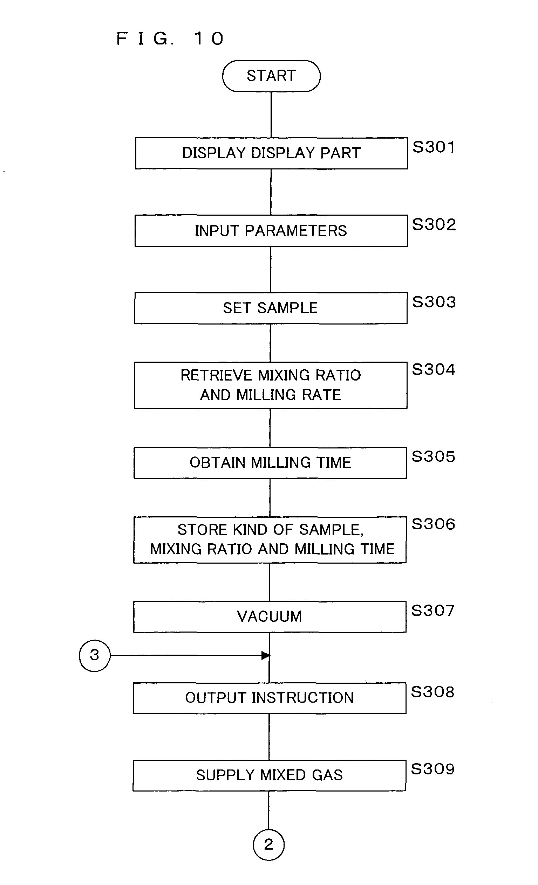

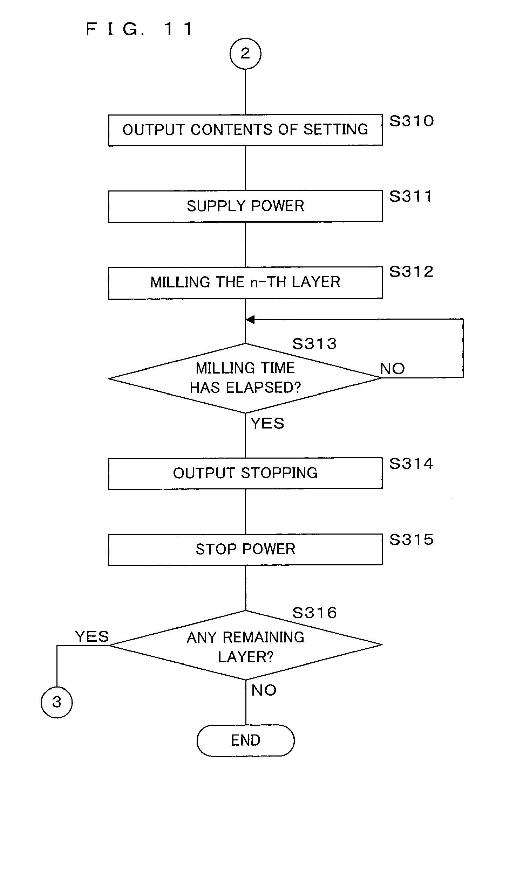

FIGS. 10 and 11 are flow charts illustrating an example of a procedure of glow discharge milling processing. In the following description, milling processing is performed on a sample S which is a stacked material obtained by stacking several different kinds of materials in the milling direction. Further, the kind of sample, the order of stacking, and the layer thickness of each layer constituting the sample S are assumed to be known.
The CPU 61 displays on the display part 66 an input screen (not illustrated) used for inputting various kinds of parameters such as a voltage-application mode, a frequency, and a duty ratio, as well as the kind of sample, the order of stacking, the layer thickness, and the milling time for each layer (step S301). The user inputs various kinds of parameters in the input screen through the operation part 67 (step S302). The user sets the sample S in the glow discharge tube 2 (step S303).

On the basis of the inputted values for the kind of sample and the order of stacking of each layer concerning the sample S, the CPU 61 searches the kind-of-sample mixing-ratio table 2T so as to retrieve a mixing ratio and a milling rate to be used in milling each layer (step S304). The CPU 61 divides the inputted layer thickness of each layer by the retrieved milling rate of each layer so as to obtain a milling time for each layer (step S305). The CPU 61 stores a list of the kind of sample, the mixing ratio, and the milling time for each layer of the sample S corresponding to the time series of milling processing, in the form of an array , into the RAM 62 (step S306). The CPU 61 causes the vacuum suction device 51 to perform vacuum suction of the glow discharge tube 2 (step S307).

Then, the CPU 61 repeats the processing from step S308 to step S316 in a number of times equal to the number of layers in the sample S. In the following description of the procedures, generalization is adopted by using the expression "the n-th layer".
The CPU 61 outputs instructions to each of the MFCs 54 so as to control the flow rates of the argon gas and the oxygen gas in accordance with the mixing ratio corresponding to the n-th layer stored in the RAM 62 (step S308). The mixer 55 mixes uniformly the argon gas and the oxygen gas whose flow rates controlled by the MFCs 54, and then supplies the uniformly mixed gas into the glow discharge tube 2 (step S309). The CPU 61 outputs to the power supply part 4 the received contents of setting (step S310). The power supply part 4 starts voltage application in accordance with the contents of setting based on the instruction from the CPU 61 (step S311). Thus, milling of the n-th layer of the sample S is performed under the mixed gas atmosphere with which the space K is filled (step S312).

On the basis of the time counting obtained from the timer 65, the CPU 61 determines whether the milling time corresponding to the n-th layer has elapsed (step S313). When it is determined that the milling time corresponding to the n-th layer has not yet elapsed (step S313: NO), the CPU 61 returns the procedure to step S313. When it is determined that the milling time corresponding to the n-th layer has elapsed (step S313: YES), the CPU 61 outputs to the power supply part 4 an instruction of stopping voltage application (step S314). When receiving from the CPU 61 the instruction for stopping voltage application, the power supply part 4 stops voltage application (Step 315).

The CPU 61 determines whether any remaining layer to be milled is present (step S316). When it is determined that any layer to be milled remains (step S316: YES), the CPU 61 returns the procedure to step S308. When it is determined that no more remaining layer to be milled is present (step S316: NO), the CPU 61 terminates the processing.

Here, in FIGS. 10 and 11, voltage application start and voltage application stop have been repeated every time one layer is milled. Instead, voltage application may be started before milling of the first layer and then voltage application may be stopped after completion of milling of the last layer. This shortens the necessary processing time.
Further, in FIGS. 10 and 11, processing for each layer has been started at step S308. Instead, the processing may be started at step S307. In this approach that processing for each layer is started at vacuum suction, milling is started in a state that the space K is filled with the mixed gas reliably having the target mixing ratio even when the mixing ratio largely varies depending on the stacked layers.

In the above-mentioned examples, a sample S which is a stacked material obtained by stacking different kinds of materials has been employed. However, even in the case of a sample S composed of a single substance, when the kind of sample is known, the kind of sample of the sample S serving as a target of milling may be inputted to the glow discharge milling apparatus 1. Then, a mixing ratio is retrieved from the kind-of-sample mixing-ratio table 2T and then milling is executed with a mixed gas having the retrieved mixing ratio.

According to the glow discharge milling apparatus 1, a suitable mixing ratio is automatically determined in accordance with the kind of sample. Further, even in a case that the sample S is composed of several different kinds of materials, after the kind of sample, the order of stacking, and the layer thickness of each layer are set up, the glow discharge milling apparatus 1 automatically executes milling processing.

The present Embodiment 3 is as described above. The other points are similar to those in Embodiments 1 and 2. Thus, like parts are designated by like reference numerals, and their detailed descriptions are omitted.

### Embodiment 4

Embodiment 4 relates to a mode that an analyzing instrument analyzing the element distribution or the element composition of the sample S is built in the glow discharge milling apparatus 1. The kind of sample of the to-be-analyzed sample S is identified from the element distribution or the element composition of the sample S obtained by the analyzing instrument and then, on the basis of this, a mixing ratio for argon gas and oxygen gas is determined from the kind-of-sample mixing-ratio table 2T. Here, the apparatus in which such an analyzing instrument is built in the glow discharge milling apparatus 1 may be recognized as a glow discharge light-emission spectroscopy apparatus.

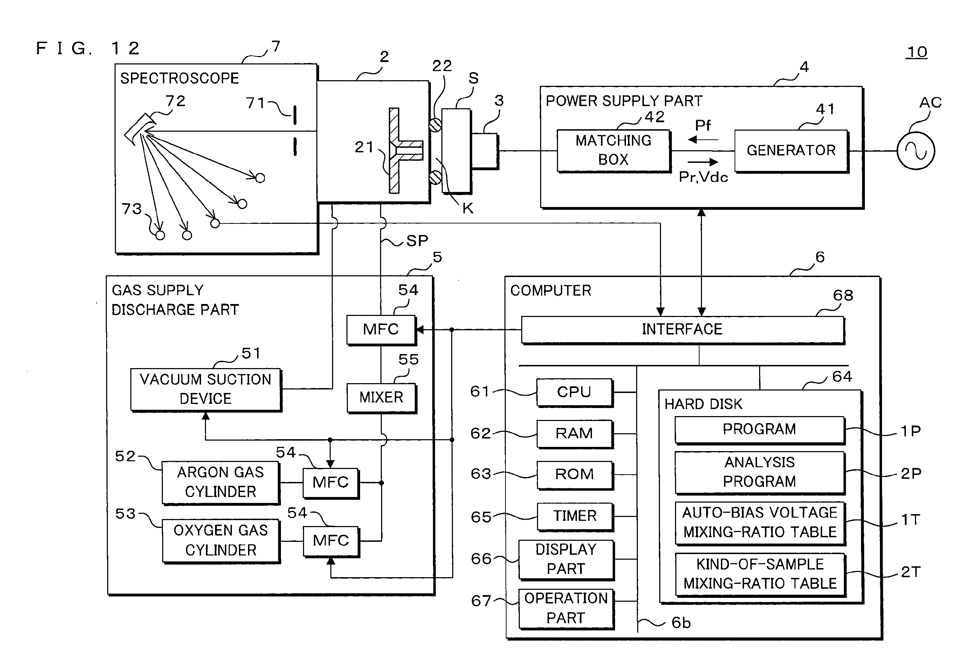

FIG. 12 is a block diagram illustrating outlines of an exemplary hardware configuration of a glow discharge milling apparatus 10 according to Embodiment 4. The glow discharge milling apparatus 10 includes a glow discharge tube 2, a sample pressing member 3, a power supply part 4, a gas supply discharge part 5, a computer 6 and a spectroscope (a measuring instrument) 7. The configuration and the function of the glow discharge tube 2, the sample pressing member 3, the power supply part 4, and the gas supply discharge part 5 are the same as those illustrated in FIG. 1. Thus, their detailed description is omitted.

The spectroscope 7 is a measuring instrument measuring the composition of elements contained in the sample S. The spectroscope 7 is connected to the glow discharge tube 2. The spectroscope 7 acquires from the glow discharge tube 2 an emission line spectrum specific to each element generated when atoms, molecules, and the like constituting the sample S under sputtering are excited in the plasma and then return to the ground states. The spectroscope 7 is connected to the computer 6 through a connection cable bundle constructed from a bundle of a plurality of cables. However, in FIG. 12, the connection cable bundle is represented by and illustrated as a single connection line. The spectroscope 7 outputs to the computer 6 electric signals indicating the presence or absence and the intensity of the emission line spectrum corresponding to the content percentage of element constituting the sample S.

The spectroscope 7 includes a slit 71, a diffraction grating 72, and a plurality of photomultiplier tubes (a photo-multiplexer) 73. The slit 71 limits the width of light transmitted from the glow discharge tube 2 to the diffraction grating 72. The diffraction grating 72 causes interference in the light so as to achieve spectroscopy of the emission line spectrum. The photomultiplier tubes 73 convert into electric signals the intensities in the emission line spectrum obtained by the spectroscopy by the diffraction grating 72. The photomultiplier tubes 73 outputs the converted electric signals to the computer 6 through the connection cable bundle.

An analysis program 2P used for analyzing the element composition of the sample S on the basis of the measured values obtained from the spectroscope 7 is installed in the hard disk 64 of the computer 6. The CPU 61 receives the electric signals outputted from the spectroscope 7 and then, on the basis of the received electric signals, analyzes the element composition of the sample S. The CPU 61 identifies the kind of sample of the sample S on the basis of the analysis result. On the basis of the identified kind of sample, the CPU 61 retrieves from the kind-of-sample mixing-ratio table 2T a mixing ratio for the mixed gas to be outputted to the MFCs 54.

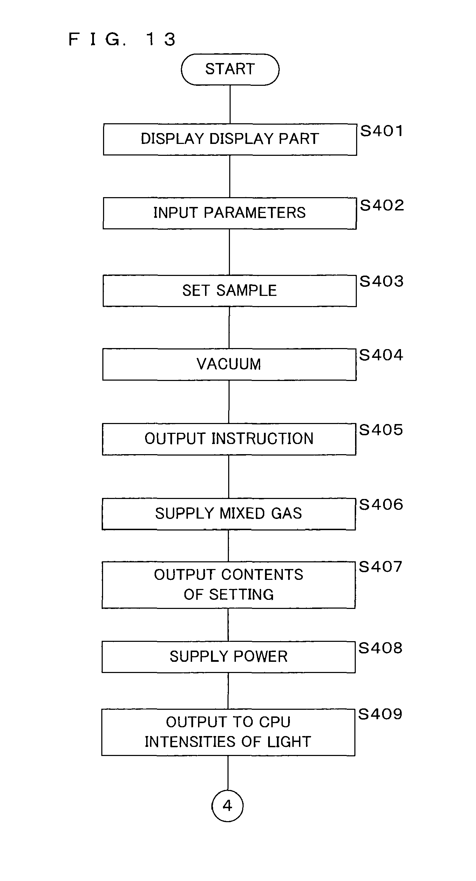

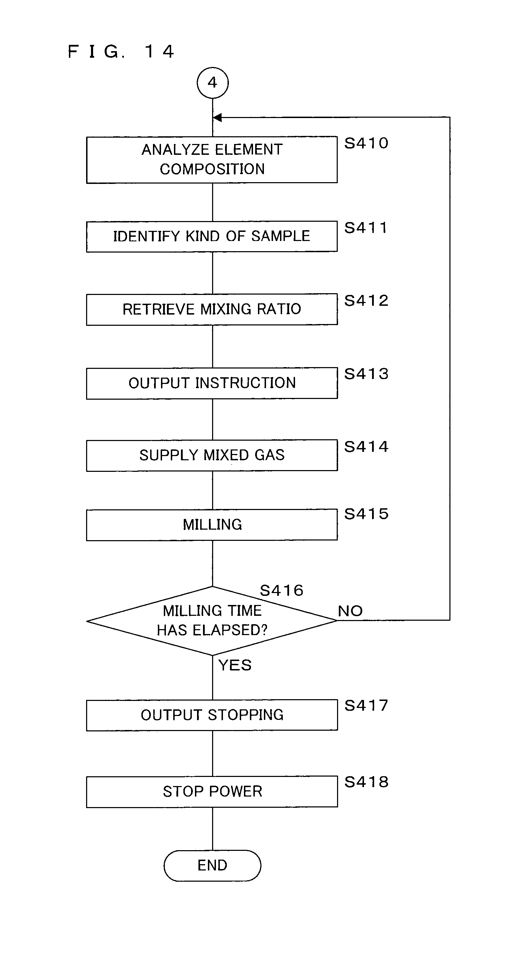

FIGS. 13 and 14 are flow charts illustrating an example of a procedure of glow discharge milling processing. In the following description, milling processing is performed on a sample S obtained by stacking several different kinds of materials in the milling direction. Further, the kind of sample, and the layer thickness of each layer constituting the sample S are assumed to be unknown.
The CPU 61 displays on the display part 66 an input screen (not illustrated) used for inputting various kinds of parameters such as a voltage-application mode, a frequency, a duty ratio, and a milling time (step S401). The user inputs various kinds of parameters in the input screen through the operation part 67 (step S402). The user sets the sample S in the glow discharge tube 2 (step S403).

The CPU 61 causes the vacuum suction device 51 to perform vacuum suction of the glow discharge tube 2 (step S404). The CPU 61 outputs an instruction to each MFC 54 such that the flow rates of the argon gas and the oxygen gas are controlled in accordance with the mixing ratio of initial setting (step S405). Here, the mixing ratio of initial setting is stored in advance in the hard disk 64. Then, the CPU 61 acquires from the hard disk 64 the mixing ratio of initial setting. The mixer 55 uniformly mixes the argon gas and the oxygen gas whose flow rates are controlled by the MFCs 54, and then supplies into the glow discharge tube 2 the uniformly mixed gas having the mixing ratio of initial setting (step S406). The CPU 61 outputs to the power supply part 4 the received contents of setting (step S407). The power supply part 4 starts voltage application in accordance with the contents of setting based on the instruction from the CPU 61 (step S408).

The spectroscope 7 performs spectroscopy of the emission line spectrum and then outputs to the CPU 61 the electric signals indicating the intensities of the light under spectroscopy (step S409). Here, during the spectroscopy of the emission line spectrum, the spectroscope 7 continues outputting to the CPU 61 the electric signals indicating the intensities of the light under spectroscopy. On the basis of the electric signals acquired from the spectroscope 7, the CPU 61 analyzes the element composition of the sample S (step S410). Then, on the basis of the analysis result, the CPU 61 identifies the kind of sample of the sample S (step S411). On the basis of the identified kind of sample, the CPU 61 retrieves a mixing ratio from the kind-of-sample mixing-ratio table 2T (step S412). The CPU 61 outputs instructions to the MFCs 54 such that the flow rates of the argon gas and the oxygen gas are controlled in accordance with the retrieved mixing ratio (step S413).

The mixer 55 mixes uniformly the argon gas and the oxygen gas whose flow rates controlled by the MFCs 54, and then supplies the uniformly mixed gas into the glow discharge tube 2 (step S414). Thus, milling of the surface of the sample S is performed under the mixed gas atmosphere with which the space K is filled(step S415). On the basis of the time counting obtained from the timer 65, the CPU 61 determines whether the received milling time has elapsed (step S416).

When it is determined that the received milling time has not yet elapsed (step S416: NO), the CPU 61 returns the procedure to step S410. When it is determined that the received milling time has elapsed (step S416: YES), the CPU 61 outputs to the power supply part 4 an instruction for stopping voltage application (step S417). When receiving from the CPU 61 the instruction for stopping voltage application, the power supply part 4 stops voltage application (step S418) and then terminates the processing.

According to the glow discharge milling apparatus 10, even when the kind of sample of the sample S and the mixing ratio for the mixed gas to be employed at the time of milling the sample S are unknown, the mixing ratio is set up automatically.
On the basis of the kind of sample identified by analysis, the glow discharge milling apparatus 10 automatically controls the mixing ratio. Thus, in addition to the case of a sample consisting of a single kind, even in the case of a sample S obtained by stacking several different kinds of materials and the case of a sample S in which deposited substance is buried, the mixing ratio is changed successively on the basis of the kind of sample identified by analysis. Thus, milling is performed always with employing a suitable mixing ratio. That is, in the course of the processing of milling the sample S, when the kind of sample serving the target of milling varies, the mixing ratio is automatically changed in accordance with the kind of sample having varied.

The present Embodiment 4 is as described above. The other points are similar to those in Embodiments 1 to 3. Thus, like parts are designated by like reference numerals, and their detailed descriptions are omitted.

## Claims

1. A glow discharge milling apparatus (1) milling a sample (S) by using glow discharge generated by, in an atmosphere of mixed gas supplied through a pipe (SP) to a glow discharge tube (2), applying a voltage between an electrode (21) located inside the glow discharge tube (2) and the sample (S) placed opposite to the electrode (21), **characterized by** comprising:
a reception part (67) receiving a mixing ratio by which inert gas and oxygen gas are to be mixed with each other;
a control part (54), in accordance with the mixing ratio received by the reception part (67), controlling the amounts of supply of the inert gas and the oxygen gas; and
a supply unit (55) mixing the inert gas and the oxygen gas with each other in accordance with the amounts of supply controlled by the control part (54) and then supplying the mixed gas to said glow discharge tube (2) through said pipe (SP).

2. The glow discharge milling apparatus (1) according to claim 1, further comprising:
a detection part (41) detecting an auto-bias voltage value associated with a voltage generated on a surface of the sample (S) on which the voltage is applied;
a storage part (64) storing auto-bias voltage values and mixing ratios of the inert gas and the oxygen gas in correspondence to each other; and
a retrieval part (61), on the basis of the auto-bias voltage value detected by said detection part (41), retrieving a mixing ratio from the contents stored in said storage part (64), wherein
said control part (54),
in accordance with the mixing ratio retrieved by the retrieval part (61), controls the amounts of supply of the inert gas and the oxygen gas.

3. The glow discharge milling apparatus (1) according to claim 2,
wherein
said reception part (67)
receives the kind of sample,
said storage part (64)
stores the kinds of samples and mixing ratios of the inert gas and the oxygen gas in correspondence to each other, and
said retrieval part (61),
on the basis of the kind of sample received by said reception part (67), retrieves a mixing ratio from the contents stored in said storage part (64).

4. The glow discharge milling apparatus (1) according to claim 2 or claim 3, wherein
said storage part (64)
stores the kinds of material of sample, mixing ratios, and milling rates in correspondence to each other,
said reception part (67),
when the sample is a stacked material obtained by stacking different materials in a milling direction, receives the kind of material, the order of stacking, and the thickness of each layer,
said retrieval part (61),
on the basis of the kind of material of each layer received by said reception part (67), retrieves a mixing ratio and a milling rate from the contents stored in said storage part (64), and
said control part (54),
in the order of stacking received by said reception part (67) and on the basis of the thickness of each layer received by said reception part (67) and the milling rate retrieved by said retrieval part (61), determines timing in which the amounts of supply of the inert gas and the oxygen gas are to be changed and then, in accordance with the mixing ratio retrieved by said retrieval part (61), controls the amounts of supply of the inert gas and the oxygen gas at the determined timing.

5. The glow discharge milling apparatus (10) according to claim 4, further comprising:
a measuring instrument (7) measuring the intensity of light emission generated by glow discharge; and
an identification part (61), on the basis of the intensity of light emission measured by the measuring instrument (7), identifying the kind or material of the sample, wherein
said retrieval part (61),
on the basis of the kind or material of the sample identified by said identification part (61), retrieves a mixing ratio from the contents stored in said storage part (64).

6. A glow discharge milling method of milling a sample (S) by using glow discharge generated by, in an atmosphere of mixed gas supplied through a pipe (SP) to a glow discharge tube (2), applying a voltage between an electrode (21) located inside the glow discharge tube (2) and the sample (S) placed opposite to the electrode (21), **characterized by** comprising:
controlling the amounts of supply of the inert gas and the oxygen gas at an arbitrary ratio of the amounts of supply;
mixing the inert gas and the oxygen gas of the controlled amounts of supply; and
supplying the mixed gas to said glow discharge tube through said pipe.
